# EUROPEAN PATENT SPECIFICATION

(11) **EP 1 017 644 B1**
(45) Date of publication and mention of the grant of the patent: **13.10.2004**
(21) Application number: 98939445.7
(22) Date of filing: 10.08.1998
(51) Int. Cl.: C03C 17/36, C03C 17/38, C03C 17/40, C23C 14/18

(54) **GLASS-BASED COPPER-MIRRORS**
KUPFERSPIEGEL AUF GLAS
MIROIRS A BASE DE CUIVRE ET DE VERRE

(30) Priority: 13.08.1997 GB 9717182
(43) Date of publication of application: 12.07.2000
(73) Proprietor: GLAVERBEL, B-1170 Bruxelles (BE)
(72) Inventor: DECROUPET, Daniel, B-5070 Fosses-la-Ville (BE); BOULANGER, Pierre, B-4218 Couthuin (BE)
(74) Representative: Farmer, Guy
(86) International application number: PCT/BE1998/000122
(87) International publication number: WO 1999/008974

(56) References cited:
- EP-A- 0 140 032
- EP-A- 0 559 967
- WO-A-91/14016
- DE-A- 4 220 621
- FR-A- 2 586 245
- GB-A- 1 074 076
- GB-A- 1 115 911
- GB-A- 1 250 142
- GB-A- 2 102 453
- GB-A- 2 206 128
- GB-A- 2 311 791
- US-A- 3 798 146

## Description

This invention relates to copper-based mirrors, especially for use in furnishings and decoration. It is particularly concerned with mirrors in which a copper layer is deposited by vacuum deposition on a vitreous substrate such as glass, for example by magnetron sputtering, evaporation under vacuum or ion plating.

Copper-based mirrors find use in applications such as furnishings and decoration because they are capable of giving an attractive appearance similar to that of gold while avoiding the high cost of using gold as such. The disadvantage is that while gold is inert and corrosion-resistant, copper is reactive and susceptible to oxidation, especially during the traditional mirror manufacturing procedures. This may result in visual defects including discoloration or haze in the reflective layer, which defects tend to increase with continued exposure to the atmosphere. Various proposals have therefore been made to protect copper mirrors against such undesired effects.

One frequently proposed anti-corrosion method, mentioned in GB patent specifications Nos. 1074076, 1250142 and 2102453, has been to treat the copper with a substituted azole, for example aminotetrazole, so as to create a protective coating on the copper surface. So-treated copper layers are however prone to changes in aspect both during and after the manufacture of the mirror. GB patent specification 2206128 addresses the problem of such changes in aspect in an azole-treated copper layer by using chemical deposition to form the copper layer and including steps in the deposition procedure which ensure a low oxygen content in the copper. The internal oxygen content is thereby reduced to below that which would react with the copper to produce the undesired discoloration.

The use of chemical methods to apply a copper layer has recently come under increased scrutiny because of their adverse environmental effects. In particular the levels of sulphate and residues of copper as such tend to require complex clean-up systems in order to fall within the relevant health and safety limits. Attention has therefore been directed to new methods of applying copper to a vitreous substrate to meet the defined standards.

We have surprisingly found that the technique of applying the copper by vacuum deposition not only satisfies the requisite health and safety standards but also when combined with appropriate means for protecting the copper provides a mirror of consistently high quality and of unusually attractive appearance.

According to the invention there is provided a mirror comprising a transparent vitreous substrate and a stack of coating layers including a reflective copper layer, characterised in that the stack comprises, in sequence from the substrate:
(a) an underlayer of transparent or absorbent material selected from metals, oxides, nitrides, oxynitrides, carbides and oxycarbides, applied by vacuum deposition and having a thickness in the range 1 to 40 nm; and
(b) a reflective layer of copper applied by vacuum deposition and having a thickness of at least 40 nm.

The invention further provides a method of forming a mirror comprising a transparent vitreous substrate and a stack of coating layers including a reflective copper layer, characterised in that there are applied to the substrate, in sequence:
(a) an underlayer of transparent or absorbent material selected from metals, oxides, nitrides, oxynitrides, carbides and oxycarbides, applied by vacuum deposition and having a thickness in the range 1 to 40 nm; and
(b) a reflective layer of copper applied by vacuum deposition and having a thickness of at least 40 nm.

A mirror including the so-formed coating stack offers several important benefits. The underlayer (a) not only bonds well to the substrate, thereby giving the stack as a whole a firm bonding to the substrate, but also in itself provides a surface to which the copper is capable of bonding strongly and evenly. The underlayer is also an important factor in providing protection of the copper against oxidation or other corrosion. It is noteworthy that the copper layer deposited by vacuum deposition has good resistance to chemical or mechanical corrosion even if it forms the outer layer of the stack. The product quality is moreover not unduly affected by slight variations in layer thickness between different mirrors.

The use of vacuum deposition also avoids health and safety problems associated with chemical deposition methods.

A particular benefit of the invention is that the use of vacuum deposition affords fine control over the respective layer thicknesses. This not only permits each of the layers to be easily applied in a defined thickness but allows accurate adjustment of the relative thickness of the layers, in particular the copper layer (b) and the underlayer (a), to achieve consistently a stack with a desired visual appearance. One of the features of the mirror that can be varied by adjustment of the relative thickness of the layers is the perceived colour in reflection, which is a major factor in determining the visual appeal of the mirror.

The specified thickness of at least 40 nm for the reflective layer of copper has the advantage of ensuring the properties of reflection and opacity sought for a mirror. The luminous reflectance of the copper layer is greater than 40% and its luminous transmission is very low, for example from 0 to 2%. Preferably the thickness of the reflective layer of copper is at least 50 nm.

The preferred version of vacuum deposition for the purposes of the invention is magnetron sputtering.

The choice of material for the underlayer (a) depends on several factors, including cost, appearance and reflectance of the mirror, and the conditions under which the mirror is to be used.

Examples of suitable transparent oxides for the underlayer (a) include alumina (Al₂O₃), hafnium oxide (HfO₂), niobium oxide (NbO), silicon oxide (SiO₂), stannic oxide (SnO₂), tantalum oxide (Ta₂O₅), titanium dioxide (TiO₂) and zinc oxide (ZnO). Examples of suitable transparent nitrides include aluminium nitride (AlN) and silicon nitride (Si₃N₄). Examples of suitable absorbent materials include stainless steel oxide *(SSOx)*, chromic oxide (Cr₂O₃), iron oxides (Fe₂O₃ or Fe₃O₄), nickel oxide (NiO), nickel-chrome oxide and silicon carbide (SiC). Examples of suitable absorbent metallic materials include titanium, chromium, stainless steel, nickel-chromium alloy, palladium, niobium, platinum, zirconium, zinc, tin and their alloys. Some metallic absorbent materials are however not convenient: for example silver deposited under vacuum as an undercoat leads to a hazy product.

The underlayer (a) can be formed of a combination of layers of two or more of the said materials, for example a ZnO layer followed by an SnO₂ layer (followed by the copper) but this generally offers no particular improvement over a single layer.

The preferred materials for the underlayer (a) are stainless steel oxide, stannic oxide and zinc oxide. Stannic oxide and zinc oxide are easily-deposited transparent oxides with a high rate of deposition. Stainless steel oxide is an absorbent oxide with a lower rate of deposition than stannic oxide or zinc oxide. However because of its absorbent properties a thinner layer is applied, which compensates for the lower deposition rate. Moreover, stainless steel oxide is absorbent in the blue portion of the spectrum and permits adjustment of the Hunter a and b optical properties of the coating stack.

Careful selection of the thickness of the underlayer (a) is important because of the effect of the underlayer on the properties of the stack, notably on its reflectance and tint. When the material of the said layer is a transparent oxide, nitride, oxynitride, carbide or oxycarbide the respective layer thickness is preferably in the range 10-25 nm. Absorbent materials have somewhat different optical properties from these other materials such that when an absorbent material forms the said underlayer its layer thickness is preferably in the range 1 to 11 nm. In the case of stainless steel oxide the layer thickness is preferably in the range 3-7 nm, most preferably 3-5 nm. If the absorbent material is a metal, its layer thickness is most preferably 1 to 5 nm.

The copper used for layer (b) preferably has a purity of substantially 100%. The copper layer may however contain traces of copper oxide if the deposition atmosphere contains traces of oxygen. The copper thickness is preferably in the range 60 to 80 nm, most preferably 67 to 77 nm. The reflectance of the copper layer reaches a maximum within the range 60 to 80 nm. A thickness in the latter range is thus of particular benefit in providing for mirrors of reproducible, consistent, uniform high quality. The thickness is most preferably 67 to 77 nm because the reflectance of the copper layer is at a consistently high level in this range. Despite the relatively high thickness of the copper layer this does not impose an undue level of additional material costs.

A further benefit of the invention is that the vacuum deposition technique allows reliable and consistent production of the low levels of thickness preferred for the respective layers of the coating stack. This is of particular importance in ensuring an attractive appearance for the mirror.

The coated mirror preferably has a reflectance (measured from the glass side) in the range 45 to 65%. Its Hunter colour co-ordinates a and b are preferably in the ranges 10 to 20 and 10 to 25 respectively.

The coating stack may further include (c) an overlayer selected from the same materials as for underlayer (a), again applied by vacuum deposition. The overlayer improves the. resistance of the coating to damage by adhesives, but otherwise is of no particular benefit. The material of the overlayer (c) is most conveniently, although not essentially, of the same material as the underlayer (a).

If an overlayer (c) is employed, in particular an oxide overlayer, then a layer of titanium metal, typically of 3 to 5 nm thickness, may also be deposited between the copper and the overlayer. The titanium layer too should preferably be applied by vacuum deposition. The deposited titanium acts as a scavenger for oxygen which might otherwise reach the copper. As the titanium used in this role is expected to be progressively converted to oxide it is usually described as a sacrificial metal.

The use of vacuum deposition for all the layers makes for simple application of the stack and ensures a high quality deposit for each of them. Surprisingly this high quality is achieved despite the relatively large number of deposition steps required.

The mirror coating may further comprise an outer paint layer. In order to meet the highest environmental standards the paint is preferably lead-free and is preferably applied by a powder deposition method. If desired the paint can include a corrosion inhibitor such as 5-aminotetrazole (ATA). It is however found that the coating stack of the invention has a high level of resistance which permits in particular the storage and transport of unpainted mirrors without harming them. The paint layer provides the stack with corrosion resistance and increases the opacity of the reflective copper layer. It should however be noted that the high opacity of the reflective copper layer as discussed above (i.e. luminous transmission of not more than 2%) is achieved even in the absence of a paint layer.

In embodiments of the invention for making decorative mirrors a mask or masks can be employed during the deposition of one or more of the layers so as to create a chosen pattern or other design.

The vitreous substrate is most typically a sheet of soda lime glass, either coloured or colourless. Prior to application of the coating stack it is not only desirable to ensure that the glass is thoroughly clean but may also be helpful to employ one or more pre-treatment steps to prepare the glass to receive the materials to be deposited. The pre-treatment may include washing the glass with a detergent solution or polishing the glass.

The invention is further described in the following nonlimiting examples, in which the substrate was sheets of soda-lime glass measuring 40 x 30 cm and having a thickness of 6 mm. Examples 1 and 2 were conducted under laboratory conditions. Examples 3 to 27 and the comparative example were conducted under industrial conditions.

### Example 1

A soda-lime glass sheet of the type described above was polished with cerium oxide, thoroughly rinsed with demineralised water and then dried with isopropyl alcohol.

The sheet was then fed through a vacuum treatment chamber in which first an underlayer (a) of zinc oxide and then a layer of copper (b) were applied by magnetron sputtering. The zinc oxide was applied to a thickness of 22 nm and the copper layer to a thickness of 70 nm. The so-coated sheet was removed from the vacuum chamber and then cut into two samples of 15 x 40 cm. One of the samples (1a) was placed in a paint chamber for the deposition of first a primer paint layer (*Merckens SK* 9165) by curtain-coating apparatus and baked for 10 minutes at 55°C to give a dry layer thickness of 30 µm. A finishing paint layer *(Merckens SK 9240)* was deposited by pulverisation and baked for 10 minutes at 150°C to give a total paint thickness of 57 µm.

The other sample (1b) was first immersed for 5 minutes in a 10 g/l solution of 5-aminotetrazole (ATA) at a temperature of 80°C and then painted in the same manner as for sample 1(a).

Both samples were then tested for optical and corrosion properties, including Hunter values L, a & b, and luminous reflectance R [R = (L/10)²], and exposed to a CASS test of accelerated weathering for 120 hours to determine loss of reflectance (given in absolute percentages), levels of corrosion (average and maximum) and surface defects upon ageing. The procedure is summarised in the accompanying Table 1 which also shows the test results obtained.

The layer thicknesses were determined by an X-ray fluorescence technique. This measures the number of impulses from the layer. The result is obtained in units of mass per unit area, e.g. mg/m². Given that the density and uniformity of the layer material are known the said result can be used to calculate a good approximation of the thickness. For copper the thickness in nm is given by dividing the value in mg/m² units by 8.9. For zinc oxide the thickness in nm is given by dividing the value in mg/m² units by 4.27.

In all the optical tests described in the examples herein the measurements were taken from the glass side.

The CASS Test, which is defined in International Standard ISO 3770-1976, includes placing the mirror in a test chamber at 50°C and subjecting it to the rapid ageing action of a spray mist of an aqueous solution containing 50 g/l sodium chloride, 0.2 g/l anhydrous cuprous chloride and glacial acetic acid in a sufficient quantity to give the spray a pH of between 3.0 and 3.1. The reflective properties of the mirror artificially aged by this aqueous acidic saline solution are compared with the reflective properties of the freshly formed mirror.

### Example 2

The process of Examples 1 was generally followed, except that the cerium oxide treatment step was replaced by washing with a potassium polyphosphate detergent *(Chemical Products' RBS 50),* followed by thorough rinsing with demineralised water and drying with isopropyl alcohol.

Zinc oxide to a thickness of 22 nm and copper to a thickness of 70 were again applied by magnetron sputtering. The so-coated sheet was again cut into two samples of 15 x 40 cm. As summarised in Table 1, one of the two samples (2b) but not the other was immersed for 5 minutes in a 10 g/l solution of 5-aminotetrazole (ATA) at a temperature of 80°C. Both samples were given a double layer of paint as described in Example 1, sample 2a to a total paint thickness of 96 µm and sample 2b to a total paint thickness of 80 µm.

Both samples were tested for optical and corrosion properties, the results being shown in the Table.

Compared with Example 1, the substitution of the cerium oxide treatment by a detergent wash produced inferior initial Hunter values and a greater loss of reflectivity after the CASS test. The samples treated with ATA achieved a smaller loss of reflectivity after the CASS test than samples not treated with ATA. On the other hand, samples treated with ATA had greater corrosion at the edges after the CASS test. The relatively high paint thickness of the samples, and the stresses this may cause, may be the reason for the loss of reflectivity and the surface defects in the CASS test.

### Examples 3 to 10

Further examples 3 to 10 were conducted generally according to the procedure of example 2. They employed *Levis* alkyd paints *(9471010* and *9471064)* rather than *Merckens* paints for the primer and finishing paint layers. The Hunter values were measured during manufacture of the mirror, prior to the painting. This does not significantly affect these values as they are little changed by the painting. A further difference was that in the initial treatment the cleaned glass was dried with a hot air stream rather than with isopropyl alcohol. The procedure and results are indicated in the accompanying Table 1. The low initial reflectance of the coatings of Examples 7 to 9 is thought to result from a small amount of oxygen contamination of the copper during its deposition under industrial conditions.

### Examples 11 to 15

Further examples 11 to 15 were conducted generally according to the procedure of examples 3 to 10 but with the difference that an overlayer was applied to the copper layer by magnetron sputtering. The overlayer comprised first a sacrificial titanium layer and then a stannic oxide layer. The respective layer thicknesses and the results obtained are shown in the Table 1. Corrosion of the mirror edges was more significant than for mirrors without the overlayer, but the mirrors with an overcoat showed a better adhesion when tested with oxime glues.

In a variant of Example 13, not shown in Table 1, the titanium layer was omitted. The results obtained in its absence were similar to those obtained in its presence.

### Examples 16 to 27

Further examples 16 to 27 were conducted generally according to the procedure of examples 3 to 10 and, like those examples, without the application of an overlayer. The difference from examples 3 to 10 was that the underlayer was formed of an absorbent metal rather than of an oxide. The respective layer thicknesses and the results obtained are shown in Table 2. In all of the examples 1 to 27, the luminous transmission value of the mirror before painting was in the range from 1 to 1.5%.

### Comparative Example

A comparative example was conducted in which the glass sheet was washed with a potassium polyphosphate detergent, *RBS 50*, followed by thorough rinsing with demineralised water and drying with isopropyl alcohol. The example differed from those according to the invention in that no underlayer was applied. A layer of copper was applied by magnetron sputtering under vacuum, and the so-coated sheet was removed from the vacuum chamber. The omission of the underlayer had a severe effect on the product quality, a haze being immediately formed by contact with the atmosphere after deposition of the copper layer, which prevented testing of the optical and corrosion qualities.

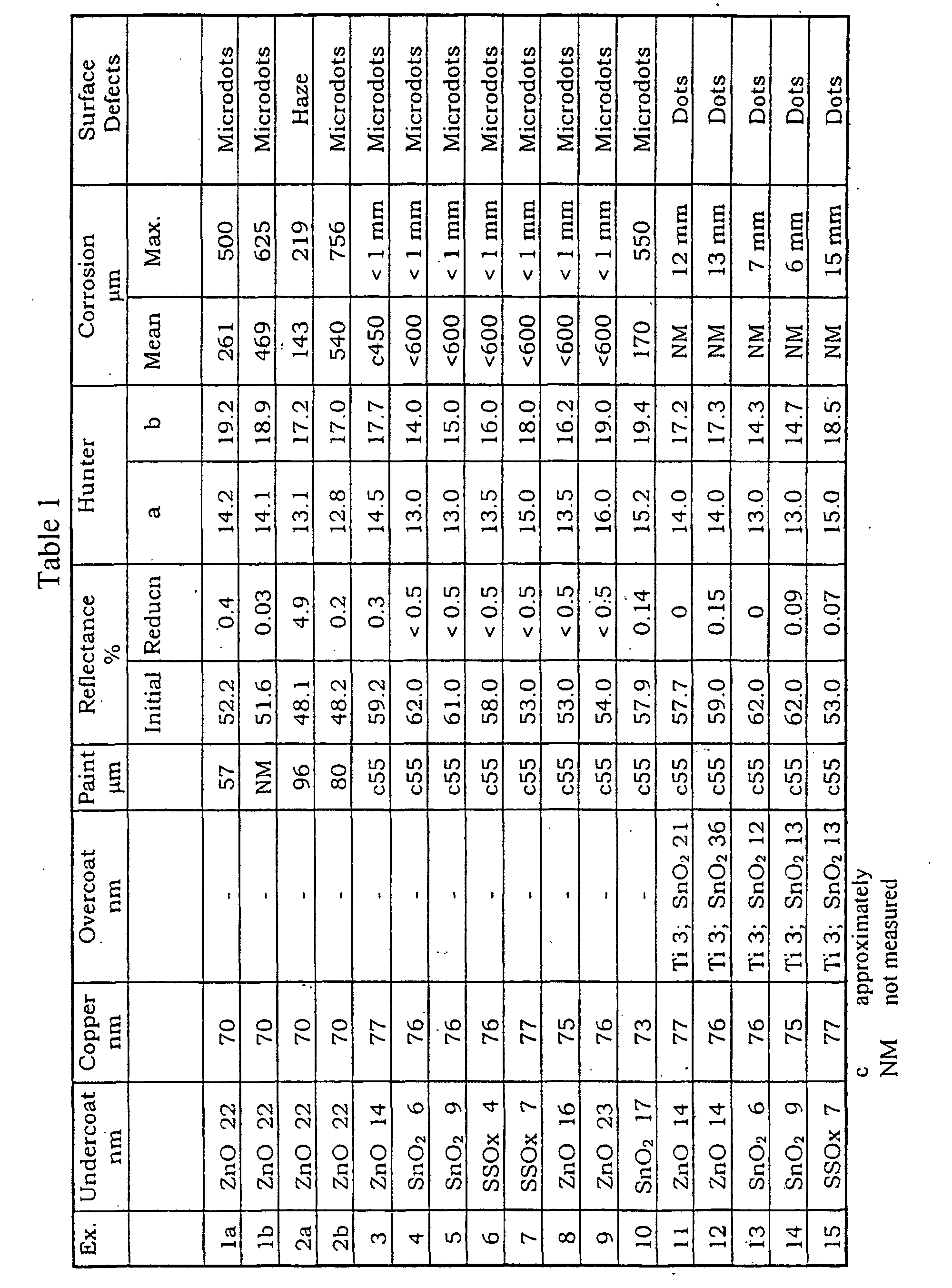

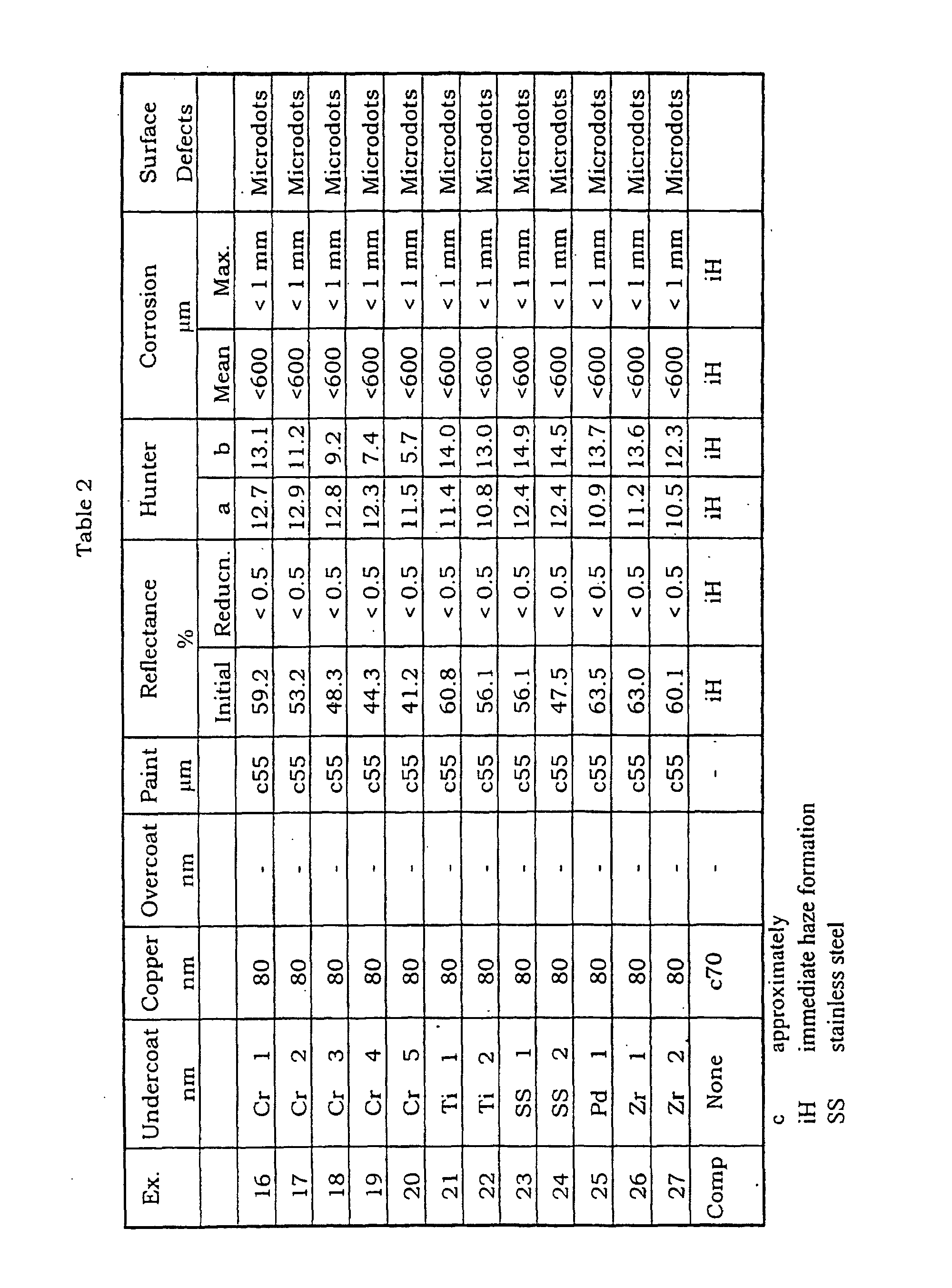

## Claims

1. A mirror comprising a transparent vitreous substrate and a stack of coating layers including a reflective layer, **characterised in that** the stack comprises, in sequence from the substrate:
(a) an underlayer of transparent or absorbent material selected from metals, oxides, nitrides, oxynitrides, carbides and oxycarbides, applied by vacuum deposition and having a thickness in the range 1 to 40 nm; and
(b) a reflective layer comprising a layer of copper applied by vacuum deposition and having a thickness of at least 40 nm.

2. A mirror as claimed in claim 1 **characterised in that** the stack comprises, in sequence from the substrate:
(a) an underlayer of transparent or absorbent material selected from metals, oxides, nitrides, oxynitrides, carbides and oxycarbides, applied by vacuum deposition and having a thickness in the range 1 to 40 nm; and
(b) a reflective layer consisting essentially of copper applied by vacuum deposition and having a thickness of at least 40 nm.

3. A mirror as claimed in any preceding claims, in which the underlayer (a) is formed of transparent material and has a thickness in the range 10 to 25 nm.

4. A mirror as claimed in claim 3, in which the transparent material is selected from one or more of alumina (Al₂O₃), hafnium oxide (HfO₂), niobium oxide (NbO), silicon oxide (SiO₂), stannic oxide (SnO₂), tantalum oxide (Ta₂O₅), titanium dioxide (TiO₂), zinc oxide (ZnO), aluminium nitride (AIN) and silicon nitride (Si₃N₄).

5. A mirror as claimed in claims 1 or 2, in which the underlayer (a) is formed of absorbent material and has a thickness is in the range 1 to 11 nm.

6. A mirror as claimed in claim 5, in which the absorbent material is selected from stainless steel oxide (*SSOx*), chromic oxide (Cr₂O₃), iron oxides (Fe₂O₃ or Fe₃O₄) and nickel oxide (NiO), nickel-chrome oxide and silicon carbide (SiC).

7. A mirror as claimed in claim 6, in which the material of the underlayer is stainless steel oxide (*SSOx*) having a layer thickness in the range 3-7 nm.

8. A mirror as claimed in claim 7, in which the material of the underlayer is stainless steel oxide *(SSOx)* having a layer thickness in the range 3-5 nm.

9. A mirror as claimed in claim 5, in which the underlayer is formed of absorbent material selected from titanium, chromium, stainless steel, nickel-chromium alloy, palladium, niobium, platinum, zirconium, zinc, tin and their alloys and has a thickness in the range 1-5 nm.

10. A mirror as claimed in claims 1 or 2. in which the material of the underlayer (a) is selected from stainless steel oxide *(SSOx)*, stannic oxide (SnO₂) and zinc oxide (ZnO).

11. A mirror as claimed in any preceding claim, in which the copper layer (b) has a thickness in the range 60 to 80 nm.

12. A mirror as claimed in any preceding claim, in which the copper layer (b) has a thickness in the range 67 to 77 nm.

13. A mirror as claimed in any preceding claim, in which the coating stack further comprises an overlayer (c) of a transparent or absorbent material selected from metals, oxides, nitrides, oxynitrides and oxycarbides, applied by vacuum deposition.

14. A mirror as claimed in claim 13, in which the coating stack further comprises between the copper layer (b) and overlayer (c) a layer of titanium metal, applied by vacuum deposition.

15. A mirror as claimed in claim 14, in which the layer of titanium metal has a thickness in the range 3 to 5 nm.

16. A mirror as claimed in any preceding claim, in which the coating stack further comprises a paint outer layer.

17. A mirror as claimed in claim 16, in which the paint is applied from powder.

18. A mirror as claimed in claim 16 or claim 17, in which the paint is lead-free.

19. A mirror according to any preceeding claims in which the reflectance measured from the glass side in the range of 45 to 65%.

20. A mirror according to any preceeding claims in which the Hunter colour co-ordinates a and b are respectively in the ranges of 10 to 20 and 10 to 25.

21. A method of forming a mirror comprising a transparent vitreous substrate and a stack of coating layers including a reflective copper layer, **characterised in that** there are applied to the substrate, in sequence:
(a) an underlayer of transparent or absorbent material selected from metals, oxides, nitrides, oxynitrides, carbides and oxycarbides, applied by vacuum deposition and having a thickness in the range 1 to 40 nm; and
(b) a reflective layer of copper applied by vacuum deposition and having a thickness of at least 40 nm.

22. A method as claimed in claim 21, in which the material of the underlayer is a transparent material selected from one or more of alumina (Al₂O₃), hafnium oxide (HfO₂), niobium oxide (NbO), silicon oxide (SiO₂), stannic oxide (SnO₂), tantalum oxide (Ta₂O₅), titanium dioxide (TiO₂), zinc oxide (ZnO), aluminium nitride (AIN) and silicon nitride (Si₃N₄).

23. A method as claimed in claim 21, in which the material of the underlayer is an absorbent material selected from stainless steel oxide *(SSOx)*, chromic oxide (Cr₂O₃), iron oxides (Fe₂O₃ or Fe₃O₄), nickel oxide (NiO), nickel-chrome oxide, silicon carbide (SiC), titanium, chromium, stainless steel, nickel-chromium alloy, palladium, niobium, platinum, zirconium, zinc, tin and their alloys.

24. A method as claimed in any of claims 21 to 23, in which there is applied by vacuum deposition to the coating stack an overlayer (c) of a transparent or absorbent material selected from metals, oxides, nitrides, oxynitrides, carbides and oxycarbides.

25. A method as claimed in claim 24, in which a layer of titanium metal is applied by vacuum deposition between the copper layer and the overlayer.

26. A method as claimed in any of claims 21 to 25, in which a paint outer layer is applied to the coating stack.

27. A method as claimed in claim 26, in which the paint is applied from powder.

28. A method as claimed in claim 26 or claim 27, in which the paint is lead-free.

29. A mirror obtainable by a method according to any of claims 21 to 28.

## Patentansprüche

1. Spiegel, umfassend ein transparentes glasartiges Substrat und einen Stapel aus Beschichtungsschichten, einschließlich einer Reflexionsschicht, **dadurch gekennzeichnet, daß** der Stapel in der Reihenfolge von dem Substrat:
(a) eine Unterschicht aus einem transparenten oder absorbierenden Material, ausgewählt aus Metallen, Oxiden, Nitriden, Oxynitriden, Carbiden und Oxycarbiden, die durch Vakuumabscheidung aufgebracht ist und eine Dicke in einem Bereich von 1 bis 40 nm aufweist, und
(b) eine Reflexionsschicht, die eine Schicht aus Kupfer umfaßt, die durch Vakuumabscheidung aufgebracht ist und eine Dicke von mindestens 40 nm aufweist,
umfaßt.

2. Spiegel, wie in Anspruch 1 beansprucht, **dadurch gekennzeichnet, daß** der Stapel in der Reihenfolge von dem Substrat:
(a) eine Unterschicht aus einem transparenten oder absorbierenden Material, ausgewählt aus Metallen, Oxiden, Nitriden, Oxynitriden, Carbiden und Oxycarbiden, die durch Vakuumabscheidung aufgebracht ist und eine Dicke in einem Bereich von 1 bis 40 nm aufweist, und
(b) eine Reflexionsschicht, die im wesentlichen aus Kupfer besteht, die durch Vakuumabscheidung aufgebracht ist und eine Dicke von mindestens 40 nm aufweist,
umfaßt.

3. Spiegel, wie in einem der vorhergehenden Ansprüche beansprucht, wobei die Unterschicht (a) aus einem transparenten Material gebildet ist und eine Dicke in einem Bereich von 10 bis 25 nm aufweist.

4. Spiegel, wie in Anspruch 3 beansprucht, wobei das transparente Material aus einem oder mehreren von Aluminiumoxid (Al₂O₃), Hafniumoxid (HfO₂), Nioboxid (NbO), Siliciumoxid (SiO₂), Zinnoxid (SnO₂), Tantaloxid (Ta₂O₅), Titandioxid (TiO₂), Zinkoxid (ZnO), Aluminiumnitrid (AIN) und Siliciumnitrid (Si₃N₄) ausgewählt ist.

5. Spiegel, wie in Anspruch 1 oder 2 beansprucht, wobei die Unterschicht (a) aus einem absorbierenden Material gebildet ist und eine Dicke in einem Bereich von 1 bis 11 nm aufweist.

6. Spiegel, wie in Anspruch 5 beansprucht, wobei das absorbierende Material aus einem Oxid von rostfreiem Stahl (SSOx), Chromoxid (Cr₂O₃), Eisenoxiden (Fe₂O₃ oder Fe₃O₄) und Nickeloxid (NiO), Nickel-Chrom-Oxid und Siliciumcarbid (SiC) ausgewählt ist.

7. Spiegel, wie in Anspruch 6 beansprucht, wobei das Material der Unterschicht ein Oxid von rostfreiem Stahl (SSOx) mit einer Schichtdicke in einem Bereich von 3 bis 7 nm ist.

8. Spiegel, wie in Anspruch 7 beansprucht, wobei das Material der Unterschicht ein Oxid von rostfreiem Stahl (SSOx) mit einer Schichtdicke in einem Bereich von 3 bis 5 nm ist.

9. Spiegel, wie in Anspruch 5 beansprucht, wobei die Unterschicht aus einem absorbierenden Material gebildet ist, das aus Titan, Chrom, rostfreiem Stahl, Nickel-Chrom-Legierung, Palladium, Niob, Platin, Zirkonium, Zink, Zinn und deren Legierungen ausgewählt ist, und eine Dicke in einem Bereich von 1 bis 5 nm aufweist.

10. Spiegel, wie in Anspruch 1 oder 2 beansprucht, wobei das Material der Unterschicht (a) aus einem Oxid von rostfreiem Stahl (SSOx), Zinnoxid (SnO₂) und Zinkoxid (ZnO) ausgewählt ist.

11. Spiegel, wie in einem vorhergehenden Anspruch beansprucht, wobei die Kupferschicht (b) eine Dicke in einem Bereich von 60 bis 80 nm aufweist.

12. Spiegel, wie in einem vorhergehenden Anspruch beansprucht, wobei die Kupferschicht (b) eine Dicke in einem Bereich von 67 bis 77 nm aufweist.

13. Spiegel, wie in einem vorhergehenden Anspruch beansprucht, wobei der Beschichtungsstapel weiter eine Überzugsschicht (c) aus einem transparenten oder absorbierenden Material, ausgewählt aus Metallen, Oxiden, Nitriden, Oxynitriden und Oxycarbiden, die durch Vakuumabscheidung aufgebracht ist, umfaßt.

14. Spiegel, wie in Anspruch 13 beansprucht, wobei der Beschichtungsstapel weiter zwischen der Kupferschicht (b) und der Überzugsschicht (c) eine Schicht aus Titanmetall, die durch Vakuumabscheidung aufgebracht ist, umfaßt.

15. Spiegel, wie in Anspruch 14 beansprucht, wobei die Schicht aus Titanmetall eine Dicke in einem Bereich von 3 bis 5 nm aufweist.

16. Spiegel, wie in einem vorhergehenden Anspruch beansprucht, wobei der Beschichtungsstapel weiter eine äußere Anstrichschicht umfaßt.

17. Spiegel, wie in Anspruch 16 beansprucht, wobei der Anstrich aus einem Pulver aufgebracht ist.

18. Spiegel, wie in Anspruch 16 oder Anspruch 17 beansprucht, wobei der Anstrich bleifrei ist.

19. Spiegel nach einem der vorhergehenden Ansprüche, wobei das Reflexionsvermögen, gemessen von der Glasseite, in einem Bereich von 45 bis 65% liegt.

20. Spiegel nach einem der vorhergehenden Ansprüche, wobei die Hunter-Farb-Koordinaten a und b in einem Bereich von 10 bis 20 bzw. 10 bis 25 liegen.

21. Verfahren zum Bilden eines Spiegels, umfassend ein transparentes glasartiges Substrat und einen Stapel von Beschichtungsschichten, einschließlich einer reflektierenden Kupferschicht, **dadurch gekennzeichnet, daß** in der Reihenfolge auf das Substrat:
(a) eine Unterschicht aus einem transparenten oder absorbierenden Material, ausgewählt aus Metallen, Oxiden, Nitriden, Oxynitriden, Carbiden und Oxycarbiden, die durch Vakuumabscheidung aufgebracht wird und eine Dicke in einem Bereich von 1 bis 40 nm aufweist, und
(b) eine Reflexionsschicht aus Kupfer, die durch Vakuumabscheidung aufgebracht wird und eine Dicke von mindestens 40 nm aufweist,
aufgebracht werden.

22. Verfahren, wie in Anspruch 21 beansprucht, wobei das Material der Unterschicht ein transparentes Material, ausgewählt aus einem oder mehreren von Aluminiumoxid (Al₂O₃), Hafniumoxid (HfO₂), Nioboxid (NbO), Siliciumoxid (SiO₂), Zinnoxid (SnO₂), Tantaloxid (Ta₂O₅), Titandioxid (TiO₂), Zinkoxid (ZnO), Aluminiumnitrid (AIN) und Siliciumnitrid (Si₃N₄), ist.

23. Verfahren, wie in Anspruch 21 beansprucht, wobei das Material der Unterschicht ein absorbierendes Material, ausgewählt aus einem Oxid von rostfreiem Stahl (SSOx), Chromoxid (Cr₂O₃), Eisenoxiden (Fe₂O₃ oder Fe₃O₄), Nikkeloxid (NiO), Nickel-Chrom-Oxid, Siliciumcarbid (SiC), Titan, Chrom, rostfreiem Stahl, Nickel-Chrom-Legierung, Palladium, Niob, Platin, Zirconium, Zink, Zinn und deren Legierungen, ist.

24. Verfahren, wie in einem der Ansprüche 21 bis 23 beansprucht, wobei durch Vakuumabscheidung auf dem Beschichtungsstapel eine Überzugsschicht (c) aus einem transparenten oder absorbierenden Material, ausgewählt aus Metallen, Oxiden, Nitriden, Oxynitriden, Carbiden und Oxycarbiden, aufgebracht wird.

25. Verfahren, wie in Anspruch 24 beansprucht, wobei eine Schicht aus Titanmetall durch Vakuumabscheidung zwischen der Kupferschicht und der Deckschicht aufgebracht wird.

26. Verfahren, wie in einem der Ansprüche 21 bis 25 beansprucht, wobei eine äußere Anstrichschicht auf den Beschichtungsstapel aufgebracht wird.

27. Verfahren, wie in Anspruch 26 beansprucht, wobei der Anstrich aus einem Pulver aufgebracht wird.

28. Verfahren, wie in Anspruch 26 oder 27 beansprucht, wobei der Anstrich bleifrei ist.

29. Spiegel, erhältlich durch ein Verfahren gemäß einem der Ansprüche 21 bis 28.

## Revendications

1. Un miroir comprenant un substrat vitreux transparent et un empilement de couches de revêtement comprenant une couche réfléchissante, **caractérisé en ce que** l'empilement comprend, en séquence à partir du substrat :
(a) une sous-couche de matériau transparent ou absorbant sélectionné parmi des métaux, oxydes, nitrures, oxynitrures, carbures et oxycarbures, appliquée par dépôt sous vide et ayant une épaisseur dans la gamme de 1 à 40 nm ; et
(b) une couche réfléchissante comprenant une couche de cuivre appliquée par dépôt sous vide et ayant une épaisseur d'au moins 40 nm.

2. Un miroir tel que revendiqué dans la revendication 1 **caractérisé en ce que** l'empilement comprend, en séquence à partir du substrat :
(a) une sous-couche de matériau transparent ou absorbant sélectionné parmi des métaux, oxydes, nitrures, oxynitrures, carbures et oxycarbures, appliquée par dépôt sous vide et ayant une épaisseur dans la gamme de 1 à 40 nm ; et
(b) une couche réfléchissante comprenant essentiellement du cuivre, appliquée par dépôt sous vide et ayant une épaisseur d'au moins 40 nm.

3. Un miroir tel que revendiqué dans l'une quelconque des revendications précédentes, dans lequel la sous-couche (a) est formée d'un matériau transparent et a une épaisseur dans la gamme de 10 à 25 mm.

4. Un miroir tel que revendiqué dans la revendication 3, dans lequel le matériau transparent est sélectionné parmi un ou plusieurs d'alumine (Al2O3), oxyde d'hafnium (HfO2), oxyde de niobium (NbO), oxyde de silicium (SiO2), oxyde d'étain (SnO2), oxyde de tantale (Ta2O5), dioxyde de titane (TiO2), oxyde de zinc (ZnO), nitrure d'aluminium (AlN) et nitrure de silicium (Si3N4).

5. Un miroir tel que revendiqué dans les revendications 1 ou 2, dans lequel la sous-couche (a) est formée d'un matériau absorbant et a une épaisseur de 1 à 11 nm.

6. Un miroir tel que revendiqué dans la revendication 5, dans lequel le matériau absorbant est sélectionné parmi oxyde d'acier inoxydable (SSOx), oxyde de chrome (Cr2O3), oxydes de fer (Fe2O3 ou Fe3O4) et oxyde de nickel (NiO), oxyde de nickel-chrome et carbure de silicium (SiC).

7. Un miroir tel que revendiqué dans la revendication 6, dans lequel le matériau de la sous-couche est de l'oxyde d'acier inoxydable (SSOx) ayant une épaisseur de couche dans la gamme de 3-7 nm.

8. Un miroir tel que revendiqué dans la revendication 7, dans lequel le matériau de la sous-couche est de l'oxyde d'acier inoxydable (SSOx) ayant une épaisseur de couche dans la gamme de 3-5 nm.

9. Un miroir tel que revendiqué dans la revendication 5, dans lequel la sous-couche est formée d'un matériau absorbant sélectionné parmi titane, chrome, acier inoxydable, alliage nickel-chrome, palladium, niobium, platine, zirconium, zinc, étain et leurs alliages et a une épaisseur dans la gamme 1-5 nm.

10. Un miroir tel que revendiqué dans les revendications 1 ou 2, dans lequel le matériau de la sous-couche (a) est sélectionné parmi oxyde d'acier inoxydable (SSOx), oxyde d'étain (SnO2) et oxyde de zinc (ZnO).

11. Un miroir tel que revendiqué dans l'une quelconque des revendications précédentes, dans lequel la couche de cuivre (b) a une épaisseur dans la gamme de 60 à 80 nm.

12. Un miroir tel que revendiqué dans l'une quelconque des revendications précédentes, dans lequel la couche de cuivre (b) a une épaisseur dans la gamme de 67 à 77 nm.

13. Un miroir tel que revendiqué dans l'une quelconque des revendications précédentes, dans lequel l'empilement comprend également une surcouche (c) d'un matériau transparent ou absorbant sélectionné parmi des métaux, oxydes, nitrures, oxynitrures et oxycarbures, appliqués par dépôt sous vide.

14. Un miroir tel que revendiqué dans la revendication 13, dans lequel l'empilement comprend également, entre la couche de cuivre (b) et la surcouche (c), une couche de titane métallique, appliquée par dépôt sous vide.

15. Un miroir tel que revendiqué dans la revendication 14, dans lequel la couche de titane métallique a une épaisseur dans la gamme de 3 à 5 nm.

16. Un miroir tel que revendiqué dans l'une quelconque des revendications précédentes, dans lequel l'empilement comprend également une couche extérieure de peinture.

17. Un miroir tel que revendiqué dans la revendication 16, dans lequel la peinture est appliquée à partir de poudre.

18. Un miroir tel que revendiqué dans la revendication 16 ou la revendication 17, dans lequel la peinture est sans plomb.

19. Un miroir selon l'une quelconque des revendications précédentes, dans lequel la réflexion lumineuse mesurée du côté du verre est dans la gamme de 45 à 65%.

20. Un miroir selon l'une quelconque des revendications précédentes, dans lequel les coordonnées de couleur Hunter a et b sont respectivement dans les gammes de 10 à 20 et de 10 à 25.

21. Une méthode de fabrication d'un miroir comprenant un substrat vitreux transparent et un empilement de couches de revêtement comprenant une couche de cuivre réfléchissante, **caractérisée en ce que** sont appliquées sur le substrat, en séquence :
(a) une sous-couche de matériau transparent ou absorbant sélectionné parmi des métaux, oxydes, nitrures, oxynitrures, carbures et oxycarbures, appliquée par dépôt sous vide et ayant une épaisseur dans la gamme de 1 à 40 nm ; et
(b) une couche réfléchissante de cuivre appliquée par dépôt sous vide et ayant une épaisseur d'au moins 40 nm

22. Une méthode telle que revendiquée dans la revendication 21, dans laquelle le matériau de la sous-couche est un matériau transparent sélectionné parmi un ou plusieurs d'alumine {Al2O3), oxyde d'hafnium (HfO2), oxyde de niobium (NbO), oxyde de silicium (Si0O), oxyde d'étain (SnO2), oxyde de tantale (Ta2O5), dioxyde de titane (TiO2), oxyde de zinc (ZnO), nitrure d'aluminium (AIN) et nitrure de silicium (Si3N4).

23. Une méthode telle que revendiquée dans la revendication 21,
dans laquelle le matériau de la sous-couche est un matériau absorbant sélectionné parmi oxyde d'acier inoxydable (SSOx), oxyde de chrome (Cr2O3), oxydes de fer (Fe2O3 ou Fe3O4) et oxyde de nickel (NiO), oxyde de nickel-chrome, carbure de silicium (SiC), titane, chrome, acier inoxydable, alliage nickel-chrome, palladium, niobium, platine, zirconium, zinc, étain et leurs alliages.

24. Une méthode telle que revendiquée dans la revendication 21, dans laquelle il est appliqué par dépôt sous vide sur l'empilement une surcouche (c) d'un matériau transparent ou absorbant sélectionné parmi des métaux, oxydes, nitrures, oxynitrures, carbures et oxycarbures.

25. Une méthode telle que revendiquée dans la revendication 24, dans laquelle une couche de titane métallique est appliquée par dépôt sous vide entre la couche de cuivre et la surcouche.

26. Une méthode telle que revendiquée dans les revendications 21 à 25, dans laquelle une couche extérieure de peinture est appliquée sur l'empilement.

27. Une méthode telle que revendiquée dans la revendication 26, dans laquelle la peinture est appliquée à partir de poudre.

28. Une méthode telle que revendiquée dans la revendication 26 ou la revendication 27, dans laquelle la peinture est sans plomb.

29. Un miroir réalisable par une méthode selon l'une des revendications 21 à 28.
